# EUROPEAN PATENT APPLICATION

(11) **EP 4 350 785 A1**
(43) Date of publication of application: **10.04.2024**
(21) Application number: 23794929.2
(22) Date of filing: 29.03.2023
(51) Int. Cl.: H01L 31/18, H01L 31/048

(54) **METHOD FOR MANUFACTURING SOLAR CELL MODULE**

(30) Priority: 28.04.2022 CN 202210484042
(71) Applicant: Anhui Huasun Energy Co., Ltd., Xuancheng, Anhui 242000 (CN)
(72) Inventor: LIN, Changjiang, Xuancheng, Anhui 242000 (CN); CAO, Kaiyin, Xuancheng, Anhui 242000 (CN)
(74) Representative: Patentanwälte und Rechtsanwalt Weiß, Arat & Partner mbB
(86) International application number: PCT/CN2023/084852
(87) International publication number: WO 2023/207494

(57) **Abstract**

A method for manufacturing a solar cell module, the method comprising: providing a first substrate; arranging a solar cell group on a side of a first region of the first substrate; after arranging the solar cell group on the side of the first region of the first substrate, arranging a first encapsulation adhesive layer on a surface of the solar cell group facing away from the first substrate; heating a sealant material by using a gluing device, a part of a surface at a side of an edge region of the first substrate being coated with a sealant layer during the heating of the sealant material by using the gluing device; arranging a second substrate on a side of the sealant layer and the solar cell group facing away from the first substrate to complete a laminated structure; and laminating the laminated structure. The method for manufacturing a solar cell module has a simple process, improves the sealing and insulating properties of the solar cell module, reduces the probability of power attenuation of a solar cell caused by moisture penetrating into the solar cell module, and prolongs the service life of the solar cell.

## Description

### CROSS-REFERENCE TO RELATED APPLICATION

The present application claims priority to the Chinese Patent Application No. 202210484042.1, filed to the Chinese Patent Office on April 28th, 2022 and entitled "METHOD OF MANUFACTURING SOLAR CELL MODULE", the entire contents of which are incorporated herein by reference.

### TECHNICAL FIELD

The present application relates to the field of solar cell production, and specifically relates to a method of manufacturing a solar cell module.

### BACKGROUND

In recent years, as traditional fossil fuels become increasingly prominent, new energy has rapidly developed, especially solar energy as one of the new energy sources that has been mainly developed. A solar module formed by using a method of manufacturing the solar cell module in the prior art has stress caused by the deformation of laminated glass. Also, it is insufficient in glue film bonding strength and higher in water vapor transmission rate of edge sealing silica gel and a glue film. At the same time, the aged glue film will reduce the bonding power when the solar module is used outdoors for a long term. And then, moisture will gradually infiltrate into the glue film to further affect cells, reducing the sealing and insulating properties of the solar module. If the solar module is used in air for a long time, the solar cells are easily eroded by water vapor and reduced the short service life of each cells.

Obviously, the method of manufacturing the solar module needs to be improved in the prior art.

### SUMMARY OF THE INVENTION

Therefore, the technical problem aims to overcome defects of low sealing and insulating properties for a method of manufacturing a solar module in the prior art. The solar cell module are low and solar cells are easily eroded by water vapor to cause power attenuation and short service life of the solar cells, thereby providing a method of manufacturing a solar cell module.

The present application provides a method of manufacturing a solar cell module, including provide the first substrate. Wherein, the first substrate includes a first region and an edge region surrounding the first region, arranging a solar cell group on a side of the first region of the first substrate. After providing the solar cell group on the side of the first region of the first substrate, providing a first encapsulation adhesive layer on a surface of the solar cell group facing away from the first substrate. Followingly, the sealant material was heated by a gluing device, wherein a part of a surface at a side of an edge region of the first substrate is coated with a sealant layer during the heating of the sealant material by using the gluing device. The sealant layer encompasses the solar cell group, comprising a central region and edge regions situated on both sides of the central region in the width direction of the sealant layer. The upper surface of the central region does not exceed the upper surfaces of the edge regions. To finalize a stacked structure, position a second substrate on the side of the sealant layer and the solar cell group facing away from the first substrate, and then laminate the stacked structure. As an option, the central region is recessed toward the first substrate relative to the edge region.

Alternatively, the width of the sealant layer in contact with the first substrate can range from 80%-100% of the maximum width of the sealant layer.

Alternatively, the gluing device comprises a glue supply barrel, a glue supply pipe, and a glue outlet part. The glue supply pipe has opposite first and second ends, with the first end connected to the outlet of the glue supply barrel, and the second end connected to the inlet of the glue outlet part, which is equipped with a glue outlet. And, the glue supply pipe consists of a flow pipe layer for conveying the sealant material and a heating pipe layer surrounding the flow pipe layer, responsible for heating the sealant material within the flow pipe layer.

Optionally, a cross-sectional shape of the glue outlet includes a rectangle, and during the process of coating the sealant layer, a long side of the glue outlet is perpendicular to a coating movement direction.

As an option, the adhesive supply pipe may include an additional thermal insulation pipe layer enveloping the heating pipe layer, accompanied by a protective pipe layer surrounding the thermal insulation pipe layer.

Optionally, the glue outlet part is provided with a metering pump; and during the process of coating the sealant layer, the pressure applied by the metering pump is in a range from 6MPa to 25MPa.

Optionally, a linear velocity of glue output volume at the glue outlet is in a range from 100mm/s to 500mm/s.

Optionally, during the process of coating the sealant layer, the distance between the glue outlet and the first substrate is in a range from 0.3mm to 2.2mm.

As an option, the gluing device a first and a second heating unit. The process of heating the sealant material with the gluing device involves utilizing the first heating unit to warm the glue supply barrel and the second heating unit to heat the heating pipe layer. Optionally, the gluing device is equipped with both a first and a second heating unit. The process of heating the sealant material with the gluing device involves utilizing using the first heating unit to heat the glue supply barrel and the second heating unit to heating pipe layer.

Optionally, the glue supply barrel is heated to a temperature ranging from 100°C to 230°C by the first heating unit.

Optionally, the heating pipe layer is heated to a temperature ranging from 100°C to 230°C by the second heating unit.

Additionally, the gluing device is equipped with a first booster pump. While heating the sealant material with the gluing device, the first booster pump is employed to exert pressure on the sealant material within the glue supply barrel, with applied pressure ranging from 6MPa to 25MPa.

Optionally, the gluing device further includes a second relay booster pump arranged on a pipeline of the glue supply pipe between the first end and the second end; and during the process of heating the sealant material by using the gluing device, a pressure applied by the second relay booster pump is in a range from 6MPa to 25MPa.

Optionally, the gluing device also features a third heating unit. In the process of heating the sealant material with the gluing device, the sealant material introduced into the glue outlet part undergoes heating from the third heating unit, ranging a temperature from 100°C to 230°C.

Optionally, the gluing device further includes a fourth heating unit. The fourth heating unit is suitable for heating the sealant, introducing into the second relay booster pump. And, the sealant introduced into the second relay booster pump, which is heated to a temperature ranging from 100°C to 230°C with the fourth heating unit.

Optionally, the method further includes: before arranging the solar cell group on the side of the first region of the first substrate, arranging a second encapsulation adhesive layer on the surface of the first region of the first substrate; the step of arranging the solar cell group on the side of the first region of the first substrate includes: arranging the solar cell group on a side of the second encapsulation adhesive layer facing away from the first substrate; The stacked structure further includes a second encapsulation adhesive layer; and during the process of laminating the stacked structure, laminating the second encapsulation adhesive layer is further included.

Optionally, prior to laminating the stacked structure, ensure that the inner side wall of the sealant layer maintains a distance from the side walls of the first encapsulation adhesive layer, the solar cell group, and the second encapsulation adhesive layer.

Optionally, the spacing distance is in a range from 0.1mm to 5.0mm.

Optionally, before laminating the stacked structure, the sealant layer has a thickness ranging from 0.5mm to 2.0mm and a width ranging from 5mm to 12mm.

Optionally, the sealant layer is made from a material including butyl sealant.

Optionally, the stacked structure is laminated according to parameters including a temperature ranging from 130°C to 150°C, a lamination time ranging from 10min to 20min, a pressure ranging from -50kPa to OkPa, and the vacuum degree in the laminator chamber ranging from 30Pa to 200Pa.

Optionally, the method comprises providing an encapsulation frame, wherein an accommodating cavity is provided in the encapsulation frame; laminating the first substrate, the solar cell group, the first encapsulation adhesive layer, the second encapsulation adhesive layer and the second substrate to form a laminated structure; after laminating the stacked structure to form the laminated structure, forming a frame glue on an inner wall surface of the accommodating cavity. And sleeving an edge region of the laminated structure in the accommodating cavity.

Optionally, the frame glue is made from a material including butyl sealant.

Optionally, the method further includes: before arranging the first encapsulation adhesive layer on the surface of the solar cell group facing away from the first substrate. And, after arranging the solar cell group on the side of the first region of the first substrate, carrying out a defect detection on the solar cell group.

Optionally, before arranging the second substrate on the side of the sealant layer and the solar cell group facing away from the first substrate. A lead wire hole is formed, and the lead wire hole passes through the second substrate and the first encapsulation adhesive layer. The solar cell group includes adjacent solar cell strings connected in parallel through bus bars, the solar cell string includes adjacent solar cells sequentially connected in series by interconnection bars. And the bus bars pass through the lead wire hole, which the method of manufacturing a solar module further includes: during the step of positioning the second substrate onto the side of the sealant layer and the solar cell group, oriented away from the first substrate, ensure the extension of bus bars towards the aspect of the second substrate distant from the first encapsulation adhesive layer through the lead wire hole. Preceding the placement of the second substrate on the side of the sealant layer and the solar cell group facing away from the first substrate, and subsequent to situating the solar cell group on the first region of the first substrate, implement the creation of a sealing filler within the lead wire hole.

Optionally, the sealing filler is made from a material including butyl sealant.

The technical solutions of the present application have the following beneficial effects: according to the method of manufacturing a solar cell module provided by the present application, during the process of heating the sealant material by using the gluing device, the part of the surface at the side of the edge region of the first substrate is coated with the sealant layer, and the sealant layer is in a heating state so that the bonding property between the sealant layer and the first substrate is improved. And the part of the surface on the side of the edge region of the first substrate is directly coated with the sealant layer by using the gluing device, and more intermediate links are not required so that the process is simplified. Before the second substrate is arranged, the sealant layer includes the central region and the edge regions located on two sides of the central region in the width direction of the sealant layer. The upper surface of the central region is not higher than the upper surfaces of the edge regions, and thus, a gap formed between the edge region on a side of the solar cell group facing the central region and the side wall of the solar cell group is avoided. The bonding property between the sealant layer and the first substrate is improved, and the gap formed between the edge region on the side of the solar cell group facing the central region and the side wall of the solar cell group is avoided, so that the sealant layer can better stop the material overflow of the first encapsulation adhesive layer, the sealing and insulating properties of the sealant layer are improved, water vapor and leaked power are better stopped from entering solar cells, not only can the safety of the solar cell module be ensured, but also the probability of power attenuation of solar cells due to water vapor infiltration into the solar cell module is reduced, and the service life of each solar cell is prolonged.

Further, the central region is sunken toward the first substrate relative to the edge region, and thus, the process difficulty is lowered.

Further, the width of the sealant layer in contact with the first substrate is 80%-100% of the maximum width of the sealant layer. Therefore, the region of the sealant layer in contact is larger with the first substrate. The sealant layer is uniformly attached to the first substrate, which is stable in pattern and can be continuously coated by the gluing device. It is ensured that the sealant layer is continuous, and the bonding property among the first substrate, the solar cell group, the first encapsulation adhesive layer and the second substrate after lamination can be improved.

Further, prior to applying the second encapsulation adhesive layer onto the surface of the solar cell group facing away from the first substrate, and after placing the solar cell group on the the first region of the first substrate, a defect detection process is carried out on the solar cell group. This defect detection can be performed on the solar cell group in advance before the second substrate is arranged, and such an operation reduces the high workload for repeated rework, greatly increases the repair efficiency, and is beneficial to the reduction of the labor cost, the increase of the utilization rate and production efficiency of a production line and the reduction of the rework cost.

Further, the encapsulation frame is provided, wherein the accommodating cavity is provided in the encapsulation frame; the first substrate, the solar cell group, and the second substrate are laminated to form a laminated structure; and the method of manufacturing a solar cell module further includes: forming a frame glue on an inner wall surface of the accommodating cavity; and sleeving an edge region of the laminated structure in the accommodating cavity, wherein the frame glue is made from a material including butyl sealant. The butyl sealant is good in chemical stability, heat stability, and electric insulation properties and stronger in gas tightness and water tightness, therefore, if the butyl sealant with a certain thickness is coated around the solar cell module during the process of manufacturing the solar cell module, the water tightness of the solar cell module can be improved to form protection again, so that the solar cell module has good sealing and insulating properties.

Further, before the second substrate is arranged on the side of the sealant layer and the solar cell group facing away from the first substrate, the lead wire hole is formed, and the lead wire hole passes through the second substrate and the first encapsulation adhesive layer; in the step of arranging the second substrate on the side of the sealant layer and the solar cell group facing away from the first substrate, the bus bars are extended to the side of the second substrate facing away from the first encapsulation adhesive layer through the lead wire hole; and after the solar cell group is arranged on the side of the first region of the first substrate and before the second substrate is arranged on the side of the sealant layer and the solar cell group facing away from the first substrate, the sealing filler is formed in the lead wire hole, and the sealing filler is made from a material including butyl sealant. Due to the good chemical stability, heat stability, and electric insulation properties as well as the stronger gas tightness and water tightness, the butyl sealant can effectively stop the situation that the water vapor enters the solar cells through the lead wire hole, and is beneficial to the improvement of the sealing and insulating properties of the solar cell module.

### BRIEF DESCRIPTION OF THE DRAWINGS

To describe the technical solutions in specific implementations of the present application or the prior art more clearly, the accompanying drawings required for describing the specific implementations or the prior art will be briefly introduced below. The accompanying drawings in the following description show only some implementations of the present application, and those of ordinary skill in the art may still derive other accompanying drawings from these accompanying drawings without creative efforts.
FIG 1 is a flow diagram of a method of manufacturing a solar cell module provided in an embodiment of the present application;
FIG 2 is a schematic structural diagram of an unlaminated solar cell module provided in an embodiment of the present application;
FIG 3 is a bottom view of a second substrate provided in an embodiment of the present application;
FIG 4 is a schematic diagram of a partial longitudinal section of the second substrate provided in an embodiment of the present application; and
FIG 5 is a schematic diagram of a longitudinal section of an encapsulated laminated structure provided in an embodiment of the present application.

Description for reference numerals in the accompanying drawings:
101-first substrate; 102-solar cell group; 103-second substrate; 104-first encapsulation adhesive layer; 105-second encapsulation adhesive layer; 200-sealant layer; W-width; T-thickness; L1-distance; L2-distance; K-lead wire hole; 300-sealing filler; 100-laminated structure; 400-encapsulation frame; and 401-frame glue.

### DETAILED DESCRIPTION

Technical solutions of the present application will be described clearly and completely below in conjunction with the accompanying drawings. Apparently, the described embodiments are only a part of the embodiments of the present application, not all the embodiments. Based on the embodiments in the present application, all other embodiments obtained by those of ordinary skill in the art without creative efforts shall fall within the protection scope of the present application.

In the description of the present application, it should be noted that directional or positional relationships indicated by terms such as "central", "upper", "lower", "left", "right", "vertical", "horizontal", "inner" and "outer" are based on directional or positional relationships as shown in the accompanying drawings, and are only to facilitate describing the present application and simplifying the description, rather than indicating or implying that the referred device or element has to have a specific direction or be constructed and operated in the specific direction, and therefore, they cannot be regarded as limitations on the present application. In addition, the terms "first", "second" and "third" may be for descriptive purposes only, and cannot be understood as indicating or implying relative importance.

In the description of the present application, it should be noted that the terms "mounted", "connected" and "connection" should be understood in a broad sense unless otherwise specified and defined, for example, "connection" may be fixed connection or detachable connection or integral connection, maybe a mechanical connection or electrical connection, maybe a direct connection or an indirect connection through an intermediate medium, and maybe the internal connection of two elements. For those of ordinary skill in the art, the specific meanings of the above terms in the present application may be understood according to specific situations.

In addition, technical features involved in different implementations in the following description of the present application may be combined without any conflicts.

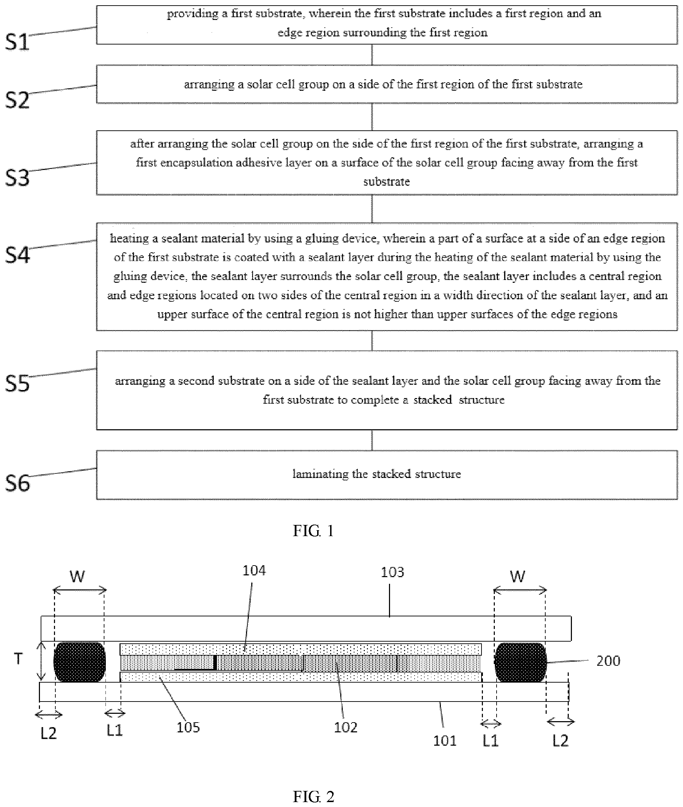

A method of manufacturing a solar cell module provided in the present application, concerning FIG 1 and FIG 2, includes:
step S1: a first substrate 101 is provided, wherein the first substrate 101 includes a first region and an edge region surrounding the first region;
step S2: a solar cell group 102 is arranged on a side of the first region of the first substrate 101;
step S3: after the solar cell group 102 is arranged on the side of the first region of the first substrate 101, a first encapsulation adhesive layer 104 is arranged on a surface of the solar cell group 102 facing away from the first substrate 101;
step S4: a sealant material is heated by using a gluing device, wherein a part of a surface at the side of an edge region of the first substrate 101 is coated with a sealant layer 200 during the heating of the sealant material by using the gluing device, the sealant layer 200 surrounds the solar cell group 102, the sealant layer includes a central region and edge regions located on two sides of the central region in a width direction of the sealant layer, and an upper surface of the central region is not higher than upper surfaces of the edge regions;
step S5: a second substrate 103 is arranged on a side of the sealant layer 200 and the solar cell group 102 facing away from the first substrate 101 to complete a stacked structure; and
step S6: the stacked structure is laminated.

According to the method of manufacturing a solar cell module provided in the present embodiment, during the process of heating the sealant material by using the gluing device, the part of the surface at the side of the edge region of the first substrate 101 is coated with the sealant layer, and the sealant layer 200 is in a heating state, so that the bonding property between the sealant layer 200 and the first substrate 101 is improved; and the part of the surface at the side of the edge region of the first substrate 101 is directly coated with the sealant layer by using the gluing device, and more intermediate links are not required, so that the process is simplified while the cost is reduced. Before the second substrate 103 is arranged, the sealant layer 200 includes the central region and the edge regions located on two sides of the central region in the width direction of the sealant layer, the upper surface of the central region is not higher than the upper surfaces of the edge regions, and thus, a gap formed between the edge region on a side of the solar cell group 102 facing the central region and the side wall of the solar cell group 102 is avoided. The bonding property between the sealant layer 200 and the first substrate 101 is improved, and the gap formed between the edge region on the side of the solar cell group 102 facing the central region and the side wall of the solar cell group 102 is avoided, so that the sealant layer 200 can better stop the material overflow of the first encapsulation adhesive layer 104, the sealing and insulating properties of the sealant layer 200 are improved, water vapor and leaked power are better stopped from entering solar cells, not only can the safety of the solar cell module be ensured, but also the probability of power attenuation of solar cells due to water vapor infiltration into the solar cell module is reduced, and the service life of each solar cell is prolonged.

The first region is suitable for holding the solar cell group 102.

Now, the stacked structure includes the first substrate 101, the solar cell group 102, the first encapsulation adhesive layer 104, the second substrate 103, and the sealant layer 200.

The width direction of the sealant layer 200 is parallel to the directions of the first substrate 101 and the second substrate 103.

In an embodiment, the central region is sunken toward the first substrate 101 relative to the edge region, and thus, the process difficulty is lowered.

In other embodiments, the central region of the sealant layer 200 is flush with the edge regions of the sealant layer 200.

The sealant layer 200 includes the central region, a first sub-edge region facing the solar cell group 102, and a second sub-edge region facing away from the solar cell group 102. The second sub-edge region surrounds the central region of the sealant layer 200, and the central region of the sealant layer 200 surrounds the second sub-edge region of the sealant layer 200.

In one embodiment, the sealant layer 200's width in contact with the first substrate 101 is 80%-100%, such as 85% of the maximum width of the sealant layer 200. This design choice ensures a larger contact area with the first substrate, resulting in a stable and uniformly attached sealant layer pattern. The use of a gluing device for continuous coating maintains the continuity of the sealant layer, contributing to improved bonding properties among the first substrate 101, the solar cell group 102, the first encapsulation adhesive layer 104, and the second substrate 103 after lamination.

In an embodiment, the gluing device includes a glue supply barrel, a glue supply pipe, and a glue outlet part, the glue supply pipe is provided with a first end and a second end which are opposite, the first end is communicated with an outlet of the glue supply barrel, the second end is communicated with an inlet of the glue outlet part, and the glue outlet part is provided with a glue outlet.

In an embodiment, before the part of the surface at the side of the edge region of the first substrate 101 is coated with the sealant layer 200, the method further includes: the gluing device being exhausted to discharge air bubbles and gaps in the gluing device, thereby avoiding the phenomenon of glue interruption when a sealant is outputted.

In the present embodiment, two glue supply barrels are used, and the two glue supply barrels are beneficial to continuous glue supply.

In an embodiment, the cross-sectional shape of the glue outlet is a rectangle, and during the process of coating the sealant layer, a long side of the glue outlet is perpendicular to a coating movement direction. The cross-sectional shape of the glue outlet is the rectangle, and by such arrangement, the pattern of the sealant layer, such as the straightness of the pattern of the sealant layer, can be effectively controlled. The sealant layer formed by setting the cross-sectional shape of the glue outlet to be the rectangle is more beneficial to the interconnection between the first encapsulation adhesive layer and the second encapsulation adhesive layer, and the appearance of the formed sealant layer is beautiful; and the glue coating height can be flexibly adjusted, which is more beneficial to the control on glue output volume and is also beneficial to the control on glue coating flatness. In other embodiments, the cross-sectional shape of the glue outlet may further include a flat ellipse. In an embodiment, the glue supply pipe includes a flow pipe layer and a heating pipe layer surrounding the flow pipe layer, the flow pipe layer is suitable for transporting the sealant material, and the heating pipe layer is suitable for heating the sealant material in the flow pipe layer.

In an embodiment, the glue supply pipe further includes a thermal insulation pipe layer surrounding the heating pipe layer and a protection pipe layer surrounding the thermal insulation pipe layer. The thermal insulation pipe layer is of a multilayer thermal insulation structure and is made from a high-temperature-resistant and heat-insulating material, thus, the heating efficiency can be increased, and the heat loss can be reduced.

A temperature sensor is further arranged in the glue supply pipe to accurately control the temperature of the sealant material in the glue supply pipe.

In an embodiment, the glue outlet part is provided with a metering pump; and the metering pump includes a pressure sensor capable of monitoring pressures during glue input and output, the metering pump can also precisely control the glue output volume, and the precision of the glue output volume is controlled within a range from 0.5% to 1.5%, such as 1%.

In other embodiments, the glue outlet part may further include other devices with functions of controlling a flow rate by changing the air pressure and monitoring the flow rate.

In an embodiment, during the process of coating the sealant layer, the pressure applied by the metering pump is in a range from 6MPa to 25MPa, such as 15MPa; if the pressure applied by the metering pump is lower than 6MPa, power supplied to the sealant is excessively low, and the degree of realizing continuous glue supply is excessively low; and if the pressure applied by the metering pump is higher than 25MPa, power supplied to the sealant is excessively high, and the flowing degree of the sealant may be excessively high, which makes it not easy to control a velocity for forming the sealant and the shape of the formed sealant.

In an embodiment, the linear velocity of glue output volume at the glue outlet is in a range from 100mm/s to 500mm/s, such as 200mm/s; if the linear velocity of glue output volume at the glue outlet is lower than 100mm/s, the glue output velocity of the sealant in the glue outlet is excessively low, which will cause an excessive large thickness of the formed sealant layer, and thus, glue overflow is easily caused during lamination to result in resource waste; and if the linear velocity of glue output volume at the glue outlet is higher than 500mm/s, the glue output velocity of the sealant in the glue outlet is excessively high, which will cause an excessively small thickness of the formed sealant layer, and due to the excessive small thickness of the sealant layer, the degree that the finally formed solar cell group is in a completely sealed environment may be relatively low, and then, fewer effects on stopping water vapor are achieved.

In an embodiment, during the process of coating the sealant layer, the distance between the glue outlet and the first substrate is in a range from 0.3mm to 2.2mm, such as 2.0mm; if the distance between the glue outlet and the first substrate is smaller than 0.3mm, the degree that the upper surface of the central region of the sealant layer is not higher than the upper surfaces of the edge regions is lower; and if the distance between the glue outlet and the first substrate is greater than 2.2mm, it is not easy to control the shape of the formed sealant layer due to the impact of gravity.

In an embodiment, the gluing device further includes a first heating unit and a second heating unit; and the step that the sealant material is heated by using the gluing device includes: the glue supply barrel being heated by using the first heating unit; and the heating pipe layer is heated by using the second heating unit.

In an embodiment, the glue supply barrel is heated to a temperature ranging from 100°C to 230°C, such as 160°C by the first heating unit; if the glue supply barrel is heated to a temperature lower than 100°C by the first heating unit, the heating temperature of the sealant in the glue supply barrel is excessively low, and the flowing degree of the sealant is improved less; if the glue supply barrel is heated to a temperature higher than 230°C by the first heating unit, the flowing degree of the sealant is excessively high, it is not easy to control the velocity for forming the sealant, and it is not easy to control the shape of the formed sealant layer due to the excessively high temperature; and if the temperature is higher than the usage temperature of the sealant, the sealant will be degraded to be invalid so as not to play an encapsulation protection role.

In an embodiment, the heating pipe layer is heated to a temperature ranging from 100°C to 230°C, such as 160°C by the second heating unit; if the heating pipe layer is heated to a temperature lower than 100°C by the second heating unit, the heating temperature of the sealant in the glue supply pipe is excessively low, and the flowing degree of the sealant is improved less; if the heating pipe layer is heated to a temperature higher than 230°C by the second heating unit, the flowing degree of the sealant is excessively high, it is not easy to control the velocity for forming the sealant, and it is not easy to control the shape of the formed sealant layer due to the excessively high temperature; and if the temperature is higher than the usage temperature of the sealant, the sealant will be degraded to be invalid so as not to play an encapsulation protection role.

In an embodiment, the gluing device further includes a first booster pump.

The method of manufacturing a solar cell module further includes: during the process of heating the sealant material by using the gluing device, the first booster pump is used to apply pressure to the sealant material in the glue supply barrel, and the pressure applied by the first booster pump is in a range from 6MPa to 25MPa, such as 15MPa; if the pressure applied by the first booster pump is lower than 6MPa, power supplied to the sealant is excessively low, and the degree of realizing continuous glue supply is excessively low; and if the pressure applied by the first booster pump is higher than 25MPa, the power supplied to the sealant is excessively high, and the flowing degree of the sealant may be excessively high, which makes it not easy to control the velocity for forming the sealant.

In an embodiment, the gluing device further includes a second relay booster pump arranged on a pipeline of the glue supply pipe between the first end and the second end.

The method of manufacturing a solar cell module further includes: during the process of heating the sealant material by using the gluing device, a pressure applied by the second relay booster pump is in a range from 6MPa to 25MPa, such as 15MPa; if the pressure applied by the second relay booster pump is lower than 6MPa, power supplied to the sealant is excessively low, and the degree of realizing continuous glue supply is excessively low; and if the pressure applied by the second relay booster pump is higher than 25MPa, the power supplied to the sealant is excessively high, and the flowing degree of the sealant may be excessively high, which makes it not easy to control the velocity for forming the sealant.

In an embodiment, the pressure bearable for the flow pipe layer is higher than the pressure bearable for the heating pipe, the pressure bearable for the flow pipe layer is in a range from 30MPa to 35MPa, such as 32MPa; and the pressure bearable for the heating pipe is in a range from 6MPa to 20MPa, such as 10MPa.

In an embodiment, the gluing device further includes a third heating unit.

The method of manufacturing a solar cell module further includes: during the process of heating the sealant material by using the gluing device, the sealant material introduced into the glue outlet part is heated by the third heating unit, and the sealant material in the glue outlet part is heated to a temperature ranging from 100°C to 230°C, such as 160°C by the third heating unit; if the sealant material in the glue outlet part is heated to a temperature lower than 100°C by the third heating unit, the heating temperature of the sealant material in the glue outlet part is excessively low, and the flowing degree of the sealant is improved less; if the sealant material in the glue outlet part is heated to a temperature higher than 230°C by the third heating unit, the flowing degree of the sealant is excessively high, it is not easy to control the velocity for forming the sealant, and it is not easy to control the shape of the formed sealant layer due to the excessively high temperature; and if the temperature is higher than the usage temperature of the sealant, the sealant will be degraded to be invalid so as not to play an encapsulation protection role.

In an embodiment, the gluing device further includes a fourth heating unit; and the fourth heating unit is suitable for heating the sealant material introduced into the second relay booster pump, and the sealant material introduced into the second relay booster pump is heated to a temperature ranging from 100°C to 230°C, such as such as 160°C by the fourth heating unit; if the sealant material introduced into the second relay booster pump is heated to a temperature lower than 100°C by the fourth heating unit, the heating temperature of the sealant material introduced into the second relay booster pump is excessively low, and the flowing degree of the sealant is improved less; if the sealant material introduced into the second relay booster pump is heated to a temperature higher than 230°C by the fourth heating unit, the flowing degree of the sealant is excessively high, it is not easy to control the velocity for forming the sealant, and it is not easy to control the shape of the formed sealant layer due to the excessively high temperature; and if the temperature is higher than the usage temperature of the sealant, the sealant will be degraded to be invalid so as not to play an encapsulation protection role.

In an embodiment, with further reference to FIG 2, the method further includes: before the solar cell group 102 is arranged on the side of the first region of the first substrate 101, a second encapsulation adhesive layer 105 is arranged on the surface of the first region of the first substrate 101; the step that the solar cell group 102 is arranged on the side of the first region of the first substrate 101 includes: the solar cell group 102 is arranged on a side of the second encapsulation adhesive layer 105 facing away from the first substrate 101, and the stacked structure further includes a second encapsulation adhesive layer 105.

In an embodiment, during the process of laminating the stacked structure, the method further includes: the second encapsulation adhesive layer 105 is laminated.

In an embodiment, the difference range between the width of the first encapsulation adhesive layer 104 and the width of the second encapsulation adhesive layer 105 is smaller than 2.0mm; a difference range between the width of the first encapsulation adhesive layer 104 and the width of the second encapsulation adhesive layer 105 is smaller than 1.0mm; a difference range of the width of the first encapsulation adhesive layer 104 and the width of the solar cell group 102 is smaller than 2.0mm; and a difference range of the width of the second encapsulation adhesive layer 105 and the width of the solar cell group 102 is smaller than 2.0mm. Thus, the laying precision is favorably improved, the positional stability of the sealant layer is favorably achieved, and the sealing property of the solar cell module is improved.

In an embodiment, before the stacked structure is laminated, an inner side wall of the sealant layer 200 is spaced from a side wall of the first encapsulation adhesive layer 104, a side wall of the solar cell group 102 and a side wall of the second encapsulation adhesive layer 105.

In an embodiment, with further reference to FIG 2, specifically, before the stacked structure is laminated, a distance L1 between the inner side wall of the sealant layer 200 and the side wall of the first encapsulation adhesive layer 104 is in a range from 0.1mm to 5.0mm, such as 2.5mm, 3.5mm and 4.5mm; if the distance L1 between the inner side wall of the sealant layer 200 and the side wall of the first encapsulation adhesive layer 104 is smaller than 2.0mm, the sealant layer may overflow to the first encapsulation adhesive layer during lamination; and if the distance L1 between the inner side wall of the sealant layer 200 and the side wall of the first encapsulation adhesive layer 104 is greater than 5.0mm, it is easy to form air bubbles in a gap possibly existing between the sealant layer and the first encapsulation adhesive layer in the finally formed solar cell module to affect the appearance and weather tolerance of the solar cell module.

In an embodiment, with further reference to FIG 2, specifically, before the stacked structure is laminated, a distance L1 between the inner side wall of the sealant layer 200 and the side wall of the solar cell group is in a range from 0.1mm to 5.0mm, such as 2.5mm, 3.5mm and 4.5mm; and if the distance L1 between the inner side wall of the sealant layer 200 and the side wall of the solar cell group is greater than 5.0mm, it is easy to form air bubbles in a gap possibly existing between the sealant layer and the solar cell group in the finally formed solar cell module to affect the appearance and weather tolerance of the solar cell module.

In an embodiment, with further reference to FIG 2, specifically, before the stacked structure is laminated, a distance L1 between the inner side wall of the sealant layer 200 and the side wall of the second encapsulation adhesive layer 105 is in a range from 0.1mm to 5.0mm, such as 2.5mm, 3.5mm and 4.5mm; if the distance L1 between the inner side wall of the sealant layer 200 and the side wall of the second encapsulation adhesive layer 105 is greater than 5.0mm, it is easy to form air bubbles in a gap possibly existing between the sealant layer and the second encapsulation adhesive layer in the finally formed solar cell module to affect the appearance and weather tolerance of the solar cell module.

In an embodiment, with further reference to FIG 2, specifically, before the stacked structure is laminated, a distance L2 between an outer side wall of the sealant layer 200 and the side wall of the first substrate 101 is in a range from 0.1mm to 5.0mm, such as 2.5mm, 3.5mm and 4.5mm; if the distance L2 between the outer side wall of the sealant layer 200 and the side wall of the first substrate 101 is smaller than 0.1mm, glue overflow is easily caused after lamination to result in resource waste and an unbeautiful appearance of the formed solar cell module; and if the distance L2 between the outer side wall of the sealant layer 200 and the side wall of the first substrate 101 is greater than 5.0mm, there is a gap on an edge of the solar cell module formed after lamination, which will cause less improvement degrees on the sealing and insulating properties of the solar cell group.

In an embodiment, with further reference to FIG 2, specifically, before the stacked structure is laminated, the thickness T of the sealant layer 200 is in a range from 0.5mm to 2.0mm, such as 1.0mm, 1.2mm and 1.5mm; if the thickness of the sealant layer is smaller than 0.5mm, the thickness of the sealant layer is excessively small, the degree that the solar cell group is in a completely sealed environment may be relatively low, and then, less effects on stopping water vapor are achieved; and if the thickness of the sealant layer is greater than 2.0mm, the thickness of the sealant layer is excessively large, glue overflow is easily caused during lamination to result in resource waste.

In an embodiment, with further reference to FIG 2, specifically, before the stacked structure is laminated, the width W of the sealant layer 200 is in a range from 5.0mm to 12.0mm, such as 6.5mm, 7.5mm and 8.5mm; if the width of the sealant layer is smaller than 5.0mm, the sealant layer plays a relatively weak role in stopping water vapor and dust in an environment from infiltrating into the solar cell group after penetrating through the sealant layer; and if the width of the sealant layer is greater than 12.0mm, the width of the sealant layer is excessively large, the sealant layer may overflow to result in waste during lamination.

In an embodiment, the sealant layer 200 includes butyl sealant. The butyl sealant is made from a material including isobutylene and a small amount of isoprene, and the butyl sealant has good chemical stability and heat stability and higher gas tightness and water tightness. Side methyl groups in a butyl rubber molecular chain in the butyl sealant are densely arranged, which limits the thermal activity of polymer molecules, therefore, the butyl sealant is low in air permeability and good in gas tightness. The air transmission rate of the butyl sealant is only 1/7 of that of natural rubber and 1/5 of that of styrene butadiene rubber, and the steam transmission rate of the butyl sealant is 1/200 of that of the natural rubber and 1/140 of that of the styrene-butadiene rubber. Table 1 shows the contrast between the water vapor transmission rate of the butyl sealant in the present embodiment and the water vapor transmission rate of an encapsulation material of the solar cell module in the prior art, which is specifically shown in table 1. The water vapor transmission rate of the butyl rubber is far lower than that of an encapsulation material of the existing solar cell module.

**Table 1**

| Material | Water vapor transmission rate (g/m²•d) | Test condition |
|---|---|---|
| Silica gel | 40-50 | Temperature: 38°C humidity: 100% |
| POE | 3-5 | Temperature: 38°C humidity: 100% |
| EPE | 7-9 | Temperature: 38°C humidity: 100% |
| EVA | 25-35 | Temperature: 38°C humidity: 100% |
| butyl sealant | 0.03 | Temperature: 23°C humidity: 100% |

A butyl rubber vulcanizate in the butyl sealant has excellent heat resistance invariance, and the application temperature of resin-vulcanized butyl rubber can reach up to 150°C to 200°C. Therefore, the butyl sealant has good heat stability, the butyl rubber molecular structure of the butyl sealant has fewer double bonds and is higher in distribution density of methyl groups on a side chain, a spatial structure of a butyl rubber molecular chain is spiral, and therefore, the butyl sealant has more methyl groups and higher elasticity to have the superior characteristic of receiving vibration and impact energy, and the rebound characteristic of the butyl rubber is not more than 20% within a wide temperature limit. Therefore, the butyl sealant is higher in mechanical force-bearing capacity and good in low-temperature resistance. The butyl sealant has rather high ozone resistance and weather aging resistance due to the high saturation of the butyl rubber molecular chain in the butyl sealant, and the ozone resistance and weather aging resistance of the butyl sealant are 10 times as high as those of the styrene-butadiene rubber. Due to the high saturation structure of the butyl rubber in the butyl sealant, the butyl sealant has higher chemical invariance, the butyl rubber has superior corrosion resistance, and the butyl sealant has strong electric insulation and corona resistance and volume resistivity which is 10 to 100 times higher than that of the general rubber. Due to the compounding of silica as a filler and sulfur or insoluble sulfur as a vulcanizing agent in the butyl rubber in the butyl sealant, physical properties and other properties such as ultraviolet resistance, heat aging resistance as well as moisture and heat resistance have been greatly improved. The butyl sealant is extremely low in water infiltration rate and very strong in physical properties, ultraviolet resistance, heat aging resistance as well as moisture and heat resistance.

In an embodiment, the solar cell group 102 includes a plurality of solar cell strings connected in parallel, and the solar cell string includes a plurality of solar cells connected in series.

In an embodiment, the solar cells may be of various types, including, but not limited to TOPCon (Tunnel Oxide Passivated Contact Solar Cells), PERC (Passivated Emitter and Rear Cells), perovskite or HJT (Heterojunction Solar Cells) solar cells, may also be imbricated, which is not limited herein.

In an embodiment, the first encapsulation adhesive layer 104 has a thickness ranging from 0.2mm to 1.0mm, such as 0.7mm; the second encapsulation adhesive layer 105 has a thickness ranging from 0.2mm to 1.0mm, such as 0.7mm; and the solar cell group 102 has a thickness ranging from 0.10mm to 0.20mm, such as 0.15mm.

In the present embodiment, the first substrate 101 is of a single-layer structure and is made from a material including glass; in other embodiments, the first substrate is of a multilayer structure and includes a protective layer, an insulating layer and a bonding layer which are stacked, the insulating layer is located between the bonding layer and the protective layer, the bonding layer is bonded with the first encapsulation adhesive layer, the protective layer is made from a material including polyvinylidene fluoride, the insulating layer is made from a material including polyethylene glycol terephthalate, and the bonding layer is made from a material including polyolefin. The first substrate plays an important role in protecting and supporting the solar cell group.

In an embodiment, the second substrate 103 is made from a material including glass; and in other embodiments, the second substrate may be further made from other flexible backplanes or transparent materials.

In an embodiment, the method of manufacturing a solar cell module further includes: before the solar cell group 102 is arranged on the side of the first region of the first substrate 101, a second encapsulation adhesive layer 105 is arranged on the surface of the first region of the first substrate 101, the second encapsulation adhesive layer 105 is made from a material including an ethylene and vinyl acetate copolymer such as an EVA glue film; and in other embodiments, the second encapsulation adhesive layer may be further made from other materials such as EPE/POE/PVB with adhesivity and optical transparency.

In an embodiment, the step that the solar cell group 102 is arranged on the side of the first region of the first substrate 101 includes: the solar cell group 102 is arranged on a side of the first encapsulation adhesive layer 104 facing away from the first substrate 101; after the solar cell group 102 is arranged on the side of the first region of the first substrate 101, a first encapsulation adhesive layer 104 is arranged on a surface of the solar cell group 102 facing away from the first substrate 101, and the first encapsulation adhesive layer 104 is made from a material including an ethylene and vinyl acetate copolymer such as an EVA glue film; and in other embodiments, the second encapsulation adhesive layer may be further made from other materials such as EPE/POE/PVB with adhesivity and optical transparency.

In an embodiment, during a process of laminating the first substrate 101, the solar cell group 102, the first encapsulation adhesive layer 104 and the second substrate 103, the first encapsulation adhesive layer 104 and the second encapsulation adhesive layer 105 are further laminated.

In an embodiment, the stacked structure is laminated according to parameters including a lamination temperature ranging from 130°C to 150°C, such as 140°C; if the lamination temperature is lower than 130°C, the degree of crosslink between the sealant layer and each of the first substrate and the second substrate is improved insufficiently; and if the lamination temperature is higher than 150°C, the sealant layer easily becomes a fluid to flow out of the solar cell module, and next, the overhigh temperature may also affect performances of the first substrate, the solar cell group and the second substrate.

In an embodiment, the stacked structure is laminated according to parameters including a lamination time ranging from 10min to 20min, such as 15min; if the lamination time is shorter than 10min, the lamination time is insufficient, which may result in a lower degree of improvement on the bonding power between the sealant layer and each of the first substrate and the second substrate; and if the lamination time is longer than 20min, the lamination time is overlong, the increase of the manufacturing efficiency of the solar cell module is reduced.

In an embodiment, the stacked structure is laminated according to parameters including a pressure value ranging from -50kPa to OkPa, such as -10kPa; if the pressure value is lower than -50kPa, the pressure is overhigh, which may result in the fissure of the solar cells in the solar cell group; and if the pressure value is higher than OkPa, the pressure value is not high enough, which may result in a lower degree of improvement on the bonding power between the sealant layer and each of the first substrate and the second substrate.

In an embodiment, the stacked structure is laminated according to parameters including the vacuum degree of lamination ranging from 20Pa to 200Pa, such as 100Pa; if the vacuum degree of lamination is smaller than 20Pa, gases in the solar cell module are not thoroughly extracted, which easily results in air bubbles between the sealant layer and each of the first substrate and the second substrate to affect the appearance and weather tolerance of the solar cell module.

In an embodiment, a device for laminating the first substrate 101, the solar cell group 102, the first encapsulation adhesive layer 104, the second encapsulation adhesive layer 105 and the second substrate 103 to form a laminated structure includes a laminator.

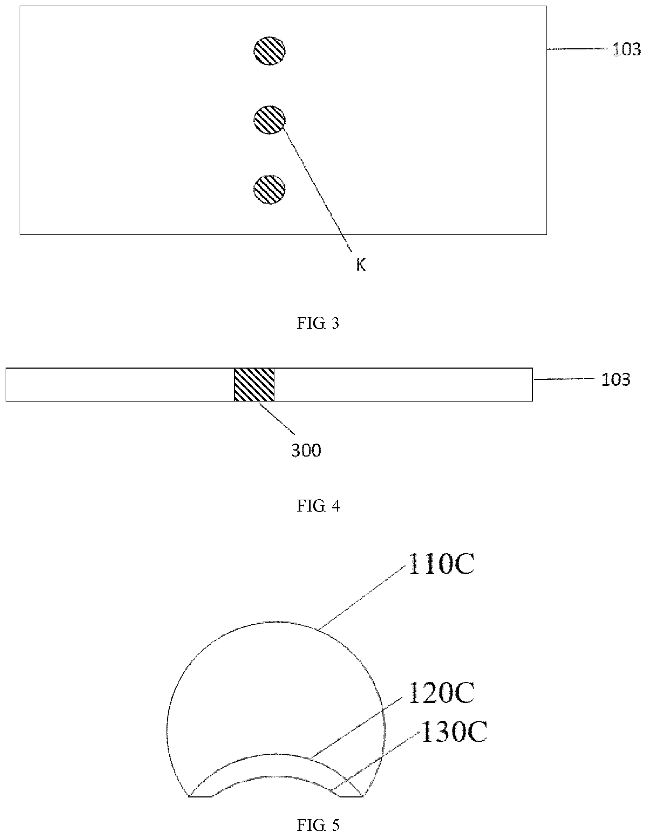

In an embodiment, regarding FIG 3 and FIG 4, before the second substrate 103 is arranged on the side of the sealant layer 200 and the solar cell group 102 facing away from the first substrate 101, a lead wire hole K is formed, and the lead wire hole K passes through the second substrate 103 and the first encapsulation adhesive layer 104. The solar cell group 102 includes adjacent solar cell strings connected in parallel through bus bars, the solar cell string includes adjacent solar cells sequentially connected in series through interconnection bars, and the bus bars pass through the lead wire hole K.

The method of manufacturing a solar cell module further includes: in the step that the second substrate 103 is arranged on the side of the sealant layer 200 and the solar cell group 102 facing away from the first substrate 101, the bus bars are extended to a side of the second substrate 103 facing away from the first encapsulation adhesive layer 104 through the lead wire hole K; and after the solar cell group 102 is arranged on the side of the first region of the first substrate 101 and before the second substrate 103 is arranged on the side of the sealant layer 200 and the solar cell group 102 facing away from the first substrate 101, a sealing filler 300 is formed in the lead wire hole K.

In an embodiment, the sealing filler 300 is made from a material including butyl sealant; and in other embodiments, the sealing filler may also be made from other materials with good chemical stability, heat stability, and electric insulation properties as well as stronger gas tightness and water tightness.

In an embodiment, the method of manufacturing a solar cell module further includes: before the first encapsulation adhesive layer 104 is arranged on the surface of the solar cell group 102 facing away from the first substrate 101, and after the solar cell group 102 is arranged on the side of the first region of the first substrate 101, defect detection is carried out on the solar cell group 102.

Before the second encapsulation adhesive layer 105 is arranged on the surface of the solar cell group 102 facing away from the first substrate 101, and after the solar cell group 102 is arranged on the side of the first region of the first substrate 101, defect detection is carried out on the solar cell group. Defect detection can be carried out on the solar cell group in advance before the second substrate is arranged, and such an operation reduces the high workload for repeated rework, greatly increases the repair efficiency, and is beneficial to the reduction of the labor cost, the increase of the utilization rate and production efficiency of a production line and the reduction of the rework cost.

Defect detection for the solar cell group includes one or more of appearance detection, subfissure detection, and false soldering detection, appearance detection aims at detecting whether the solar cell group is damaged, subfissure detection aims at detecting whether the solar cells in the solar cell group are fissured, and the false soldering detection aims at detecting whether false soldering exists between each of the solar cells in the solar cell group and a solder strip.

In an embodiment, if it is detected that the appearance of the solar cell group is damaged when appearance detection is performed on the solar cell group, for example, the solar cell group is damaged, a new solar cell group has to be changed until the solar cell group is checked to be qualified.

In another embodiment, if it is detected that there are fissured solar cells in the solar cell group when the subfissure detection is performed on the solar cell group, the fissured solar cell group is required to be repaired until the solar cell group is checked to be qualified.

In another embodiment, if it is detected that false soldering exists between each of the solar cells in the solar cell group and the solder strip when the false soldering detection is performed on the solar cell group, a false soldering position between a false-soldered solar cell and the solder strip is required to be resoldered until the solar cell group is checked to be qualified.

In the prior art, the rework rate of the solar cell module is in a range from 15% to 20%, and therefore, a lot of manpower is required for repair work; by using the method of manufacturing a solar cell module provided in the present embodiment, the workload for repeated rework can be greatly reduced, the repair efficiency is greatly increased, operators can be reduced by 1 to 2, and thus, the labor cost is reduced.

In an embodiment, the method of manufacturing a solar cell module, about FIG 5, further includes: an encapsulation frame 400 is provided, and an accommodating cavity is formed in the encapsulation frame 400; and the first substrate 101, the solar cell group 102, the first encapsulation adhesive layer 104 and the second substrate 103 are laminated to form a laminated structure 100.

In an embodiment, the encapsulation frame 400 includes an aluminum alloy frame. In other embodiments, the encapsulation frame may further include an encapsulation frame capable of playing a sealing role and made from other materials.

In an embodiment, after the stacked structure is laminated to form the laminated structure, a frame glue 401 is formed on an inner wall surface of the accommodating cavity; and an edge region of the laminated structure 100 is sleeved in the accommodating cavity.

In an embodiment, the frame glue is made from a material including butyl sealant. In other embodiments, the frame glue may be further made from other materials with good chemical stability, heat stability, and electric insulation properties as well as stronger gas tightness and water tightness.

Since the butyl sealant has good chemical stability, heat stability, and electric insulation properties as well as stronger gas tightness and water tightness, the situation that water vapor enters solar cells through the lead wire hole can be effectively stopped, the sealing and insulating properties of the solar cell module can be favorably improved, not only can the safety of the solar cell module be ensured, but also the probability of power attenuation of the solar cells due to water vapor infiltration into the solar cell module is favorably reduced, the reduction of power generation capacity of the solar cells is avoided, and the service life of each solar cell is favorably prolonged.

The above-mentioned embodiments are merely intended to clearly describe examples, rather than to limit the implementations. Those of ordinary skill in the art can also make other variations or alterations in different forms based on the above-mentioned description. It is unnecessary and impossible to exhaustively list all the implementations herein. Apparent variations or alterations derived from these still fall within the protection scope of the present disclosure.

## Claims

1. A method of manufacturing a solar cell module, wherein the method comprises:
providing a first substrate, wherein the first substrate comprises a first region and an edge region surrounding the first region;
arranging a solar cell group on a side of the first region of the first substrate;
after arranging the solar cell group on the side of the first region of the first substrate, arranging a first encapsulation adhesive layer on a surface of the solar cell group facing away from the first substrate;
heating a sealant material by using a gluing device, wherein a part of a surface at a side of the edge region of the first substrate is coated with a sealant layer during the heating of the sealant material by using the gluing device, the sealant layer surrounds the solar cell group, the sealant layer comprises a central region and edge regions located on two sides of the central region in a width direction of the sealant layer, and an upper surface of the central region is not higher than upper surfaces of the edge regions;
arranging a second substrate on a side of the sealant layer and the solar cell group facing away from the first substrate to complete a stacked structure; and
laminating the stacked structure.

2. The method of manufacturing a solar cell module of claim 1, wherein the central region is sunken toward the first substrate relative to the edge region; and
optionally, the width of the sealant layer in contact with the first substrate is 80%-100% of the maximum width of the sealant layer.

3. The method of manufacturing a solar cell module of claim 1, wherein the gluing device comprises a glue supply barrel, a glue supply pipe and a glue outlet part, the glue supply pipe is provided with a first end and a second end which are opposite, the first end is communicated with an outlet of the glue supply barrel, the second end is communicated with an inlet of the glue outlet part, and the glue outlet part is provided with a glue outlet;
the glue supply pipe comprises a flow pipe layer and a heating pipe layer surrounding the flow pipe layer, the flow pipe layer is suitable for transporting the sealant material, and the heating pipe layer is suitable for heating the sealant material in the flow pipe layer;
optionally, a cross-sectional shape of the glue outlet comprises a rectangle, and during the process of coating the sealant layer, a long side of the glue outlet is perpendicular to a coating movement direction;
optionally, the glue supply pipe further comprises a thermal insulation pipe layer surrounding the heating pipe layer and a protection pipe layer surrounding the thermal insulation pipe layer;
optionally, the glue outlet part is provided with a metering pump; and during the process of coating the sealant layer, the pressure applied by the metering pump is in a range from 6MPa to 25MPa;
optionally, a linear velocity of glue output volume at the glue outlet is in a range from 100mm/s to 500mm/s; and
optionally, during the process of coating the sealant layer, the distance between the glue outlet and the first substrate is in a range from 0.3mm to 2.2mm.

4. The method of manufacturing a solar cell module of claim 3, wherein the gluing device further comprises a first heating unit and a second heating unit;
the step of heating the sealant material by using the gluing device comprises: heating the glue supply barrel by using the first heating unit; and heating the heating pipe layer by using the second heating unit;
optionally, the glue supply barrel is heated to a temperature ranging from 100°C to 230°C by the first heating unit;
optionally, the heating pipe layer is heated to a temperature ranging from 100°C to 230°C by the second heating unit;
optionally, the gluing device further comprises a first booster pump; and during the process of heating the sealant material by using the gluing device, the first booster pump is used to apply pressure to the sealant material in the glue supply barrel, and the pressure applied by the first booster pump is in a range from 6MPa to 25MPa;
optionally, the gluing device further comprises a second relay booster pump arranged on a pipeline of the glue supply pipe between the first end and the second end; and during the process of heating the sealant material by using the gluing device, a pressure applied by the second relay booster pump is in a range from 6MPa to 25MPa;
optionally, the gluing device further comprises a third heating unit; and during the process of heating the sealant material by using the gluing device, the sealant material introduced into the glue outlet part is heated by the third heating unit, and the sealant material in the glue outlet part is heated to a temperature ranging from 100°C to 230°C by the third heating unit; and
optionally, the gluing device further comprises a fourth heating unit; the fourth heating unit is suitable for heating the sealant material introduced into the second relay booster pump, and the sealant material introduced into the second relay booster pump is heated to a temperature ranging from 100°C to 230°C by the fourth heating unit.

5. The method of manufacturing a solar cell module of any one of claims 1 to 4, wherein the method further comprises: before arranging the solar cell group on the side of the first region of the first substrate, arranging a second encapsulation adhesive layer on the surface of the first region of the first substrate;
wherein the step of arranging the solar cell group on the side of the first region of the first substrate comprises: arranging the solar cell group on a side of the second encapsulation adhesive layer facing away from the first substrate; the stacked structure further comprises a second encapsulation adhesive layer;
during the process of laminating the stacked structure, laminating the second encapsulation adhesive layer is further comprised;
optionally, before laminating the stacked structure, an inner side wall of the sealant layer is spaced from a side wall of the first encapsulation adhesive layer, a side wall of the solar cell group and a side wall of the second encapsulation adhesive layer; and
optionally, a spacing distance is in a range from 0.1mm to 5.0mm.

6. The method of manufacturing a solar cell module of claim 5, wherein before laminating the stacked structure, the sealant layer has a thickness ranging from 0.5mm to 2.0mm and a width ranging from 5mm to 12mm; and
optionally, the sealant layer is made from a material comprising butyl sealant.

7. The method of manufacturing a solar cell module of claim 5, wherein the stacked structure is laminated according to parameters comprising a temperature ranging from 130°C to 150°C, a lamination time ranging from 10min to 20min, a pressure value ranging from -50kPa to OkPa, and the vacuum degree in a chamber of a laminator used is in a range from 30Pa to 200Pa.

8. The method of manufacturing a solar cell module of claim 5, wherein the method comprises providing an encapsulation frame, wherein an accommodating cavity is provided in the encapsulation frame; and laminating the first substrate, the solar cell group, the first encapsulation adhesive layer, the second encapsulation adhesive layer and the second substrate to form a laminated structure;
after laminating the stacked structure to form the laminated structure, forming a frame glue on an inner wall surface of the accommodating cavity, and sleeving an edge region of the laminated structure in the accommodating cavity; and
optionally, the frame glue is made from a material comprising butyl sealant.

9. The method of manufacturing a solar cell module of claim 1, wherein the method further comprises:
before arranging the first encapsulation adhesive layer on the surface of the solar cell group facing away from the first substrate, and after arranging the solar cell group on the side of the first region of the first substrate, carrying out a defect detection on the solar cell group.

10. The method of manufacturing a solar cell module of claim 5, wherein before arranging the second substrate on the side of the sealant layer and the solar cell group facing away from the first substrate, a lead wire hole is formed, and the lead wire hole passes through the second substrate and the first encapsulation adhesive layer;
the solar cell group comprises adjacent solar cell strings connected in parallel through bus bars, the solar cell string comprises adjacent solar cells sequentially connected in series through interconnection bars, and the bus bars pass through the lead wire hole;
the method of manufacturing the solar cell module further comprises: the step of arranging the second substrate on the side of the sealant layer and the solar cell group facing away from the first substrate, extending the bus bars to a side of the second substrate facing away from the first encapsulation adhesive layer through the lead lead wire hole; and after arranging the solar cell group on the side of the first region of the first substrate and before arranging the second substrate on the side of the sealant layer and the solar cell group facing away from the first substrate, forming a sealing filler in the lead lead wire hole; and
optionally, the sealing filler is made from a material comprising butyl sealant.
